# EUROPÄISCHE PATENTSCHRIFT

(11) **EP 3 683 332 B1**
(45) Veröffentlichungstag und Bekanntmachung des Hinweises auf die Patenterteilung: **07.06.2023**
(21) Anmeldenummer: 20152819.7
(22) Anmeldetag: 21.01.2020
(51) Int. Cl.: C23C 14/02, C23C 14/06, C23C 14/30, C23C 14/34

(54) **SCHNEIDWERKZEUG MIT RÄUMLICH STRUKTURIERTER BESCHICHTUNG**
CUTTING TOOL WITH SPATIALLY STRUCTURED COATING
OUTIL DE COUPE POURVU DE REVÊTEMENT STRUCTURÉ SPATIAL

(30) Priorität: 21.01.2019 DE 102019200682
(43) Veröffentlichungstag der Anmeldung: 22.07.2020
(73) Patentinhaber: Fraunhofer-Gesellschaft zur Förderung der angewandten Forschung e.V., 80686 München (DE); Technische Universität Dresden, 01069 Dresden (DE)
(72) Erfinder: Beyer, Eckhard, 01328 Dresden (DE); Roch, Teja, 01277 Dresden (DE)
(74) Vertreter: Pfenning, Meinig & Partner mbB

(56) Entgegenhaltungen:
- EP-A1- 1 182 274
- DE-A1-102017 121 684

## Beschreibung

Die Erfindung betrifft ein Schneidwerkzeug mit einem Trägersubstrat und einer räumlich strukturierten Beschichtung, die mindestens eine Lage, die mit sp2 und sp3 hybridisiertem Kohlenstoff gebildet ist, aufweist, und Verfahren zu dessen Herstellung.

Bei der Wahl des Materials für Schneidwerkzeuge oder Messerklingen müssen mehrere unterschiedliche Kriterien berücksichtigt werden, die typischerweise nicht von einem einzigen Material gleich gut abgedeckt werden. Diese Kriterien betreffen insbesondere Schärfegrad, Optik, Verschleiss- und Korrosionsbeständigkeit sowie Gleit- und Hafteigenschaften.

Ein hoher Schärfegrad bei Messern wird beispielsweise durch die Verwendung von kohlenstoffhaltigen Stählen erreicht. Diese sind zäher als hochlegierte rostfreie Stähle, was beispielsweise für große Messerklingen vorteilhaft sein kann. Insbesondere sind weniger Karbidbildner (z.B. Chrom) vorhanden, wodurch feinere Gefügestrukturen und damit höherer Schärfegrade erreichbar sind. Dadurch vereinfacht sich auch das Nachschleifen. Nachteilig wirkt sich das Fehlen verschleißbeständiger Karbide auf die Schneidhaltigkeit der Klingen aus. Durch das Fehlen entsprechender Legierungsbestandteile sind Kohlenstoffstähle auch nicht rostfrei und können insbesondere bei säurehaltigen Lebensmitteln zu Verfärbungen oder auch eisenhaltigem Geschmack führen.

Im Gegensatz zu Kohlenstoffstahl existieren eine Reihe von hochlegierten Messerstählen, die insbesondere hohe Mengen an Chrom (z.B. 14 %) enthalten. Weitere Bestandteile mit niedrigeren Anteilen sind insbesondere Kohlenstoff (z.B. < 2 %), Vanadium (z.B. 4 %) oder Molybdän (z.B. 2 %). Derartige Messer sind korrosionsbeständiger als reiner Kohlenstoffstahl, aber gleichzeitig auch spröder, schwieriger nachzuschleifen und zeichnen sich durch geringere Schärfegrade aus.

Ein hybrider Stahl, der alternierend aus hartem Kohlenstoffstahl und weichem, kohlenstoffarmen Stahl aufgebaut ist, wird als Damastahl bezeichnet. Dieser weist hohe Härten, geringe Sprödigkeit und Bruchsicherheit auf, ist jedoch auch nicht rostfrei. Eine rostfreie Variante ist der sogenannte Damastahl, der pulvermetallurgisch aus rostfreien Stählen hergestellt wird. Derartige Stähle sind jedoch in der Regel aufwändig in der Fertigung und damit teuer.

Eine interessante Alternative stellen Beschichtungen aus Kohlenstoff dar, insbesondere DLC-Beschichtungen. Nachteilig an einer DLC-Schicht ist das optische Erscheinungsbild, da kleinste Verunreinigungen sichtbar sind. Typischerweise wird von Konsumenten eine schwarze Schicht gefordert, wohingegen DLC-Schichten typischerweise Anthrazit erscheinen. Aus diesen Gründen werden DLC-Beschichtungen beispielsweise nur auf einem schmalen Streifen an der Schneide der Klinge aufgebracht. Weiterhin weisen DLC-Schichten keine Antihafteigenschaften auf.

So sind aus EP 1 182 274 A1 ein diamantbeschichtetes Hartmetall-Schneidwerkzeug und ein Verfahren zu seiner Herstellung bekannt.

DE 10 2017 121 684 A1 betrifft ein Verfahren zum Erzeugen einer strukturierten Oberfläche.

Es ist daher Aufgabe der Erfindung, Beschichtungen und Verfahren zu deren Herstellung vorzuschlagen, die sich hinsichtlich Schärfegrad, Optik, Verschleiss- und Korrosionsbeständigkeit sowie Gleit- und Hafteigenschaften möglichst variabel funktionalisieren lassen.

Erfindungsgemäß wird diese Aufgabe mit einem Schneidwerkzeug, das die Merkmale des Anspruchs 1 aufweist, gelöst. Die Aufgabe kann mit dem in Anspruch 8 beschriebenen Verfahren gelöst werden. Vorteilhafte Ausgestaltungen und Weiterbildungen der Erfindung können mit den in den untergeordneten Ansprüchen bezeichneten Merkmalen realisiert werden.

In der vorliegenden Erfindung weist ein Schneidwerkzeug ein Trägersubstrat, eine auf dem Trägersubstrat angeordnete Beschichtung und eine Schneidkante, wobei die Beschichtung mit mindestens einer Lage, die mit sp2 und sp3 hybridisiertem amorphem Kohlenstoff gebildet ist, auf Weiterhin weist die Lage der Beschichtung, die mit sp2 und sp3 hybridisiertem Kohlenstoff gebildet ist, eine dreidimensionale Strukturierung auf, wobei streifenförmige, kreisförmige, kreisringförmige oder polygonale Bereiche dieser Strukturierung größerer Schichtdicke mit streifenförmigen, kreisförmigen, kreisringförmigen oder polygonalen Bereichen dieser Strukturierung kleinerer oder keiner Schichtdicke und/oder streifenförmige, kreisförmige, kreisringförmige oder polygonale Bereiche dieser Strukturierung, die ein kleineres sp2/sp3 Hybridisierungsverhältnis aufweisen, mit streifenförmigen, kreisförmigen, kreisringförmigen oder polygonalen Bereichen dieser Strukturierung, die einen ein höheres sp2/sp3 Hybridisierungsverhältnis aufweisen, alternierend abwechselnd nebeneinander angeordnet sind.

Das Trägersubstrat des Schneidwerkzeugs kann dabei aus einem Metall, einer metallischen Legierung wie beispielsweise Stahl, Damastahl oder einem Trägerblech gebildet sein.

Eine Lage der Beschichtung, die mit sp2 und sp3 hybridisiertem Kohlenstoff gebildet ist, wird im Folgenden auch als amorphe Kohlenstoffschicht bezeichnet. Eine solche amorphe Kohlenstoffschicht weist Eigenschaften auf, die zwischen denen von reinem Grafit (sp2 hybridisiert) und Diamant (sp3 hybridisiert) liegen. Beispielsweise kann eine amorphe Kohlenstoffschicht eine diamantähnliche Härte, gleichzeitig aber auch eine gute Schichthaftung und hohe Verschleißbeständigkeit aufweisen. In der vorliegenden Erfindung ist keine Lage der Beschichtung durch kristallinen oder polykristallinen Diamant gebildet. Die Schneidkante kann so ausgebildet sein, dass keine Strukturierung oder Profilierung an der Schneidkante vorhanden ist.

Unter einer Schneidkante des Schneidwerkzeugs ist diejenige Kante des Schneidwerkzeugs zu verstehen, die zumindest ein Kantensegment, das bei einem Schneidvorgang als erstes in Berührung mit dem Schnittgut kommt, aufweist. Mit der Berührung der Schneidkante mit dem Schnittgut beginnt der Trenn- und/oder Schneidevorgang. Die Schneidkante sollte eine geradlinige oder sich kontinuierlich verändernde Kontur aufweisen.

Eine weitere Lage der Beschichtung, die auf der von der Lage der Beschichtung, die mit sp2 und sp3 hybridisiertem Kohlenstoff gebildet ist, abgewandten Oberfläche des Trägersubstrats angeordnet ist, kann als thermische Spritzschicht ausgebildet sein. Eine weitere Lage der Beschichtung, die als thermische Spritzschicht ausgebildet ist, kann auch eine weitere äußere Seitenfläche des Schneidwerkzeugs bilden.

Eine dreidimensionale Strukturierung einer oder mehrerer Lagen der Beschichtung kann unter Verwendung einer Maskierung während eines physikalischen Gasabscheidungsverfahrens (PVD) und/oder durch Laserbestrahlung erfolgen, wie weiter unten näher beschrieben. Außerdem kann auch das Trägersubstrat, auf das die Beschichtung aufgebracht wird, streifenförmig, kreisförmig oder polygonal strukturiert sein. Auch dadurch kann eine wellenförmige Schneidkante gebildet werden.

Aufgrund der Anordnung und der dreidimensionalen Strukturierung mindestens einer Lage der Beschichtung, die mit sp2 und sp3 hybridisiertem Kohlenstoff gebildet ist, kann das Schneidwerkzeug mehrere Anfordernisse erfüllen. Insbesondere, können Schneidverhalten, Verschleißverhalten, Korrosionsbeständigkeit im Bereich der Beschichtung und optisches Erscheinungsbild des Schneidwerkzeugs verbessert werden.

Die streifenförmigen Bereiche der Strukturierung sind mit ihren mittleren Längsachsen vorzugsweise parallel zueinander ausgerichtet. Besonders vorzugsweise bilden die mittleren Längsachsen der streifenförmigen Bereiche einen rechten Winkel mit einer Schneidkante des Schneidwerkzeugs. Es können aber auch andere Geometrien und Muster der dreidimensionalen Strukturierung realisiert werden. So können beispielsweise kreisförmige, kreisringförmige, polygonale (quadratische, tri-diagonale, hexagonale) oder trihexagonale (Kagome) Gitterstrukturen gebildet werden. Die Wahl der Gitterstruktur kann dabei sowohl das optische Erscheinungsbild also auch die physikalischen Eigenschaften, wie z.B. mechanische Widerstandsfähigkeit, positiv beeinflussen.

Die Breite der streifenförmigen Bereiche kann je nach Herstellungsverfahren über mehrere Größenordnungen variieren. Bei einer Maskierung mittels Metalldrähten kann die Breite der streifenförmigen Bereiche zwischen 0,5 mm und 2 mm liegen, vorzugsweise ist die Breite der streifenförmigen Bereiche dann kleiner als 1 mm. Mittels Laserbestrahlung durch einen cw Laser kann eine Breite der streifenförmigen Bereiche zwischen 20 µm und 500 µm erzielt werden. Bei einer Laserbestrahlung unter Verwendung eines gepulsten Lasers lassen sich streifenförmige Bereiche mit einer Breite zwischen 1 µm und 30 µm erzeugen. Vorteilhaft wirkt es sich aus, wenn die streifenförmigen Bereiche mit kleinerer oder keiner Schichtdicke und/oder einem größeren sp2/sp3 Hybridisierungsverhältnis bzw. größeren Anteil an sp2 hybridisiertem Kohlenstoff eine Breite kleiner als 30 µm aufweisen.

Die dreidimensionale Strukturierung einer Lage der Beschichtung, die mit sp2 und sp3 hybridisiertem Kohlenstoff gebildet ist, erfolgt so, dass streifenförmige, kreisförmige, kreisringförmige oder polygonale Bereiche größerer Schichtdicke mit streifenförmigen, kreisförmigen, kreisringförmigen oder polygonalen Bereichen kleinerer oder keiner Schichtdicke alternierend abwechselnd nebeneinander angeordnet sind. Die Differenz zwischen der Schichtdicke streifenförmiger, kreisförmiger, kreisringförmiger oder polygonaler Bereiche kleinerer oder keiner Schichtdicke und der Schichtdicke streifenförmiger, kreisförmiger, kreisringförmiger oder polygonaler Bereiche größerer Schichtdicke liegt im Bereich 0,1 µm bis 50 µm, vorzugsweise im Bereich 0,1 µm und 10 µm liegen, besonders vorzugsweise im Bereich 1 µm und 5 µm. Beispielsweise kann durch eine periodische Variation der Schichtdicke eine mikroskopisch wellenförmige oder sägezahnförmige Struktur gebildet werden.

Die dreidimensionale Strukturierung einer Lage der Beschichtung, die mit sp2 und sp3 hybridisiertem Kohlenstoff gebildet ist, kann auch so erfolgen, dass streifenförmige, kreisförmige, kreisringförmige oder polygonale Bereiche dieser Strukturierung, die ein kleineres sp2/sp3 Hybridisierungsverhältnis bzw. einen kleineren Anteil an sp2 hybridisiertem Kohlenstoff aufweisen, mit streifenförmigen, kreisförmigen, kreisringförmigen oder polygonalen Bereichen dieser Strukturierung, die ein größeres sp2/sp3 Hybridisierungsverhältnis bzw. einen höheren Anteil an sp2 hybridisiertem Kohlenstoff aufweisen, alternierend abwechselnd nebeneinander angeordnet sind.

Insbesondere durch Laserbestrahlung kann das Hybridisierungsverhältnis einer amorphen Kohlenstoffschicht beeinflusst werden. Dabei kann ein harter, diamantähnlicher Kohlenstoff in einen weicheren, grafitähnlichen Kohlenstoff lokal definiert umgewandelt werden. Eine dreidimensionale Strukturierung mittels Laserbestrahlung kann dabei sowohl durch einen abtragenden Laserprozess als auch durch eine lokale Modifikation der Phase des Kohlenstoffs (Grafitisierung) erreicht werden.

Auch durch einen unterschiedlich starken Verschleiß bzw. eine unterschiedlich starke Abtragung von laserstrukturiertem Werkstoff im Vergleich zu nicht laserstrukturierten Bereichen bei der Verwendung/Benutzung des Schneidwerkzeugs kann auch eine Schichtdickenvariation, z.B. in Form einer wellenförmigen oder sägezahnartigen Struktur, entstehen. Beispielsweise kann der Verschleiß der laserstrukturierten Bereiche so stark fortschreiten, dass die Schneidkante und/oder die Schneidfläche aus mindestens zwei verschiedenen Bereichen gebildet ist, wobei die mindestens zwei verschiedenen Bereiche jeweils aufeinanderfolgenden Lagen der Beschichtung zuzuordnen sind. Damit können die unterschiedlichen Eigenschaften dieser zwei Lagen gleichzeitig genutzt werden. Beispielsweise kann eine Lage zu besseren Antihafteigenschaften führen, während die andere Lage zu einer verbesserten Schärfe des Schneidwerkzeugs beiträgt. Eine Lage, die unter der die äußere Seitenfläche bildende Lage angeordnet ist, kann dazu streifenförmig frei gelegt werden.

Eine oder mehrere Lagen der Beschichtung können mit zusätzlichen chemischen Elementen dotiert sein. Vorzugsweise kann mindestens eine Lage der Beschichtung, die mit sp2 und sp3 hybridisiertem Kohlenstoff gebildet ist, mit einem zusätzlichen chemischen Element dotiert sein. Vorteilhaft ist es beispielsweise eine amorphe Kohlenstoffschicht mit Fluor zu dotieren, um das Gleitverhalten zu verbessern. Eine Dotierung mit Silizium, Titan oder Wolfram erhöht die Verschleißbeständigkeit. Die Korrosionsbeständigkeit kann durch eine Dotierung mit Chrom positiv beeinflusst werden. Auch das Benetzungsverhalten, Reflexion bzw. Farbe können durch eine entsprechende Dotierung verändert werden.

Für die Dotierung können Metalle oder Halbmetalle aber auch Nichtmetalle verwendet werden. Weitere mögliche Dotierungselemente sind Vanadium, Molybdän, Hafnium, Wolfram oder Stickstoff. Eine diamantähnliche Kohlenstoffschicht kann auch mit mehreren chemischen Elementen und/oder deren chemischer Verbindungen dotiert sein. Solche komplexe Dotierungstargets sind beispielsweise Nitrate, Oxide, Boride oder Silizide.

Eine Lage der Beschichtung kann auch einen graduellen Schichtaufbau aufweisen. Vorzugsweise kann mindestens eine Lage der Beschichtung, die mit sp2 und sp3 hybridisiertem Kohlenstoff gebildet ist, einen graduellen Schichtaufbau aufweisen, wobei die Dichte und/oder das Hybridisierungsverhältnis sich stufenweise oder kontinuierlich entlang einer Richtung, die parallel zur Normalen der äußeren Seitenfläche des Schneidwerkzeugs ausgerichtet ist verändert ist/sind.

Bei einem solchen graduellen Schichtaufbau kann zum Beispiel der Härtegrad einer Schicht nach außen hin abnehmen oder zunehmen oder erst abnehmen und dann zunehmen oder erst zunehmen und dann abnehmen. Durch eine entsprechende Regelung der Beschichtungsprozesse können auch andere Härtegradprofile realisiert werden. Ein Vorteil eines graduellen Schichtaufbaus besteht darin, dass die Schneidkante und/oder die Schneidflächen eines Schneidwerkzeugs länger scharf gehalten werden als bei einer Beschichtung mit einheitlichem Härtegrad.

Es können auch mehrere Lagen einer Beschichtung auf das Trägersubstrat aufgebracht werden, wobei zwei oder mehrere Lagen der Beschichtung unterschiedliche Dotierungselemente, Dichten und/oder Hybridisierungsverhältnisse des Kohlenstoffs aufweisen können. Beispielsweise können dotierte oder nicht dotierte amorphe Kohlenstoffschichten unterschiedlicher Härte bzw. mit unterschiedlichem Verschleißverhalten gebildet werden.

Ebenso besteht die Möglichkeit, dünne Zwischenschichten zu bilden, welche die Haftbeständigkeit nachfolgender Lagen der Beschichtung verbessern. Solche Haftvermittlerschichten können z.B. aus Chrom, Titan, Titannitrid, Niobium, Wolfram oder Hafnium bestehen. Vorzugsweise ist zwischen einer Oberfläche des Trägersubstrats und mindestens einer Lage der Beschichtung, die mit sp2 und sp3 hybridisiertem Kohlenstoff gebildet ist, eine Haftvermittlerschicht aus Chrom oder Titannitrid ausgebildet.

Insbesondere wirkt es sich vorteilhaft aus, wenn vor dem Aufbringen einer amorphen Kohlenstoffschicht, eine bis zu 200 nm dicke Schicht aus Chrom auf einer Oberfläche des Trägersubstrats gebildet wird, bevor eine amorphe Kohlenstoffschicht abgeschieden wird.

Alternativ oder zusätzlich zu einer Haftvermittlerschicht kann auch mindestens eine Spritzschicht ausgebildet sein. Eine Spritzschicht kann mit einem thermischen Spritzverfahren erhalten werden. Eine Haftvermittlerschicht und/oder eine thermische Spritzschicht kann dazu dienen mechanische Spannungen zwischen zwei Lagen einer Beschichtung oder einer Lage der Beschichtung und dem Trägersubstrat auszugleichen. Weiterhin kann die thermische Spritzschicht so ausgebildet sein, dass die Verschleißbeständigkeit der thermischen Spritzschicht zwischen der des Ausgangswerkstoffes (z.B. Stahl) und der amorphen Kohlenstoffschicht liegt. Dadurch kann die Schneidhaltigkeit zusätzlich positiv beeinflusst werden.

Schichthaftung und Verschleiß können auch durch eine Oberflächenvorbehandlung des Trägersubstrats oder einzelner Lagen der Beschichtung beeinflusst werden. Beispielsweise kann mittels Nitrieren eine harte Randschicht, eine sogenannte Nitrierschicht, als eine Lage der Beschichtung entstehen. Vorzugsweise ist zwischen einer Oberfläche des Trägersubstrats und mindestens einer Lage der Beschichtung, die mit sp2 und sp3 hybridisiertem Kohlenstoff gebildet ist, eine nitrierte Randschicht ausgebildet.

Diese Randschicht reduziert den sogenannten "Eierschaleneffekt" bzw. die Gefahr von Schichtabplatzungen. Weiterhin kann eine nitrierte Randschicht sowohl eine positive Stützwirkung für eine nachfolgende amorphe Kohlenstoffschicht bewirken als auch die Korrosionsbeständigkeit des Schneidwerkzeugs verbessern.

Vorzugsweise beträgt die Tiefe der Nitrierung zwischen 1 µm und 200 µm. Eine nitrierte Randschicht kann auch eine dreidimensionale Strukturierung aufweisen, wobei streifenförmige, kreisförmige, kreisringförmige oder polygonale Bereiche mit großer Nitriertiefe und streifenförmige, kreisförmige, kreisringförmige oder polygonale Bereiche mit kleinerer Nitriertiefe alternierend abwechselnd nebeneinander angeordnet sein können. Bevorzugt korrespondiert eine solche dreidimensionale Strukturierung der Nitrierschicht mit der dreidimensionalen Strukturierung einer nachfolgenden amorphen Kohlenstoffschicht. Dabei schließen bevorzugt streifenförmige Bereiche einer amorphen Kohlenstoffschicht mit großer (kleiner) Schichtdicke an streifenförmige Bereiche einer nitrierten Randschicht mit großer (kleiner) Nitriertiefe an.

Zwischen mindestens einer Lage der Beschichtung, die mit sp2 und sp3 hybridisiertem Kohlenstoff gebildet ist, und einer Oberfläche des Trägersubstrats, auf der die Beschichtung angeordnet ist, kann eine weitere Lage der Beschichtung, die als Nitrierschicht oder Haftvermittlerschicht aus Chrom oder Titannitrid gebildet ist, angeordnet sein.

Eine weitere Lage der Beschichtung, die als nitrierte Randschicht ausgebildet ist, kann auch eine dreidimensionale Strukturierung aufweisen, wobei Bereiche größerer Nitriertiefe mit Bereichen kleinerer Nitriertiefe alternierend abwechselnd nebeneinander angeordnet sein können.

Ebenso können Lagen der Beschichtung mit unterschiedlichen Härtegraden alternierend abwechselnd nebeneinander ausgebildet sein. Auf diese Art kann beispielsweise ein Messer mit vorteilhaft abwechselnden Schichtfolgen ohne aufwendige Schmiedearbeiten hergestellt werden.

Ein Verfahren zur Herstellung eines Schneidwerkzeugs, bei dem eine Oberflächenbehandlung eines Trägersubstrats durchgeführt wird, umfasst die folgenden Schritte:
Zunächst kann eine Reinigung des Trägersubstrats nasschemisch erfolgen. Das Trägersubstrat wird in eine Vakuumkammer eingebracht, die evakuiert wird. Nach dem Evakuieren auf einen Kammerdruck von vorzugsweise 10⁻³ mbar - 10² mbar wird die Oberfläche des Trägersubstrats mittels Metallionensputtern feingereinigt. Diese Feinreinigung entfernt ggf. vorhandene Oxide oder andere Oberflächenkontaminationen und aktiviert die Oberfläche des Trägersubstrats.

Das Metallionensputtern kann unter Verwendung von Chrom oder Titan erfolgen, die ein Prozessgas (z.B. Argon) in der Vakuumkammer anregen, welches dann in Richtung einer zu beschichtenden Oberfläche des Trägersubstrats eventuell unter Zufuhr von Stickstoff beschleunigt wird.

In einem nächsten Schritt, wird mindestens eine Lage der Beschichtung, die mit sp2 und sp3 hybridisiertem Kohlenstoff gebildet ist, mittels eines Lichtbogenprozesses unter Einsatz eines Kohlenstofftargets auf das Trägersubstrat aufgebracht. Dabei kann auch mit mindestens einer Lage, die mit sp2 und sp3 hybridisiertem Kohlenstoff gebildet ist, eine Schneidkante und eine äußere Seitenfläche des Schneidwerkzeugs, die an eine Schneidkante des Schneidwerkzeugs anschließt, gebildet werden.

Während des Aufbringens und/oder nach dem Aufbringen einer Lage der Beschichtung, die mit sp2 und sp3 hybridisiertem Kohlenstoff gebildet ist, wird eine dreidimensionale Strukturierung ausgebildet.

Die dreidimensionale Strukturierung kann unter Verwendung einer die dreidimensionale Strukturierung vorgebenden Maske, die zwischen dem Kohlenstofftarget und der zu beschichtenden Oberfläche des Trägersubstrats während des Aufbringens dieser Lage mittels des Lichtbogenprozesses angeordnet ist, gebildet werden.

Die dreidimensionale Strukturierung kann auch so gebildet werden, dass mit mindestens einem Laserstrahl ein lokal definierter Werkstoffabtrag durchgeführt wird, der zu streifenförmigen, kreisförmigen, kreisringförmigen oder polygonalen Bereichen mit keiner oder kleinerer Schichtdicke und streifenförmigen, kreisförmigen, kreisringförmigen oder polygonalen Bereichen mit einer oder größerer Schichtdicke, der mit sp2 und sp3 hybridisiertem Kohlenstoff gebildeten Schichtführt. Bereiche mit keiner Schichtdicke werden nicht beschichtet oder es erfolgt dort ein vollständiger Abtrag der Lage der Beschichtung, die mit sp2 und sp3 hybridisiertem Kohlenstoff gebildet ist.

Eine dreidimensionale Strukturierung kann auch unter Einsatz mindestens eines Laserstrahls durch eine lokal definierte Modifizierung der Lage, bei der streifenförmige, kreisförmige, kreisringförmige oder polygonale Bereiche mit einem größerensp2/sp3 Hybridisierungsverhältnis, alternierend neben streifenförmigen, kreisförmigen, kreisringförmigen oder polygonalen Bereichen, die ein kleineres sp2/sp3 Hybridisierungsverhältnis aufweisen, angeordnet werden, ausgebildet werden.

Eine weitere Lage der Beschichtung, die auf der von der Lage der Beschichtung, die mit sp2 und sp3 hybridisiertem Kohlenstoff gebildet wird, abgewandten Oberfläche des Trägersubstrats angeordnet werden kann, kann als thermische Spritzschicht ausgebildet werden. Eine weitere Lage der Beschichtung, die als thermische Spritzschicht ausgebildet werden kann, kann auch eine weitere äußere Seitenfläche des Schneidwerkzeugs bilden.

Während des Aufbringens einer Lage der Beschichtung, die mit sp2 und sp3 hybridisiertem Kohlenstoff gebildet ist, kann auch eine Dotierung durch Zufuhr von Prozessgasen oder Dotierungstargets erfolgen. Der Volumenstrom dieser zusätzlichen Dotierungsstoffe kann beliebig geregelt werden, so dass auch ein gradueller Schichtaufbau entstehen kann bei der sich die Dotierungselemente und/oder die Dotierungsdichte innerhalb einer Schicht ändert.

Vor dem Aufbringen einer Lage der Beschichtung, die mit sp2 und sp3 hybridisiertem Kohlenstoff gebildet ist, kann mindestens eine weitere Lage der Beschichtung als eine Haftvermittlerschicht aus Chrom oder Titannitrid auf der Oberfläche des Trägersubstrats, auf der die Beschichtung angeordnet wird, gebildet werden. Vorzugsweise wird eine Haftvermittlerschicht mit einer Dicke von bis zu 200 nm gebildet. Dies kann mittels DC-Lichtbogenverdampfung erfolgen, wobei der Lichtbogen mit einer elektrischen Spannung bevorzugt im Bereich von 15 V -20 V und einer elektrischen Stromstärke bevorzugt im Bereich von 5 A -150 A ausgebildet wird.

Vor dem Aufbringen einer Lage der Beschichtung, die mit sp2 und sp3 hybridisiertem Kohlenstoff gebildet ist, kann mindestens eine weitere Lage als eine nitrierte Randschicht auf der Oberfläche des Trägersubstrats, auf der die Beschichtung angeordnet wird, gebildet werden, wobei während des Nitrierens vorzugsweise eine dreidimensionale Strukturierung unter Verwendung einer Maske und/oder mittels Laserstrahlung ausgebildet wird.

Beim Nitrieren erfolgt eine thermochemische Behandlung oder Laserbehandlung des Trägersubstrats unter Zufuhr von Stickstoff. Dabei entsteht eine harte Randschicht, die auch als nitrierte Randschicht bezeichnet wird. Dadurch kann der Härtegrad und auch die Verschleißbeständigkeit des Schneidwerkzeugs erhöht werden.

Die effektiven Nitrierzeiten sollten im Vergleich zu konventionellen Nitrierprozessen kurz gehalten werden, vorzugsweise kürzer als eine Stunde. Ein längeres und tieferes Nitrieren kann zu einer starken Erhöhung der Oberflächenrauheit führen und eventuell eine Nachbearbeitung erforderlich machen. Nachteilig an einer solchen kurzen Behandlung ist, dass die Stützwirkung durch die Nitrierung geringer ist, was jedoch für viele Anwendungen eines Schneidwerkzeugs unkritisch ist.

Besteht das Trägersubstrat aus Stahl oder Damastahl, sollte die Nitriertemperatur typischerweise unterhalb der Anlasstemperatur des entsprechenden Stahls liegen. Speziell bei nichtrostenden Stählen geht durch das Abbinden von Chrom zu Chromnitrid die passivierende Wirkung des Chroms verloren, die Korrosionsbeständigkeit sinkt. Vorteilhaft ist daher das Nitrieren bei einer Temperatur, die kleiner als 500 Grad Celsius ist, bevorzugt bei einer Temperatur zwischen 320 Grad Celsius und 420 Grad Celsius .

Zwischen mindestens einer Lage der Beschichtung, die mit sp2 und sp3 hybridisiertem Kohlenstoff gebildet wird, und einer Oberfläche des Trägersubstrats, auf der die Beschichtung angeordnet wird, kann auch eine weitere Lage der Beschichtung, die als Nitrierschicht oder Haftvermittlerschicht aus Chrom oder Titannitrid gebildet wird, angeordnet werden.

Es kann auch eine weitere Lage der Beschichtung als nitrierte Randschicht ausgebildet werden. Die nitrierte Randschicht kann mit einer dreidimensionalen Strukturierung gebildet werden, wobei Bereiche größerer Nitriertiefe mit Bereichen kleinerer Nitriertiefe alternierend abwechselnd nebeneinander angeordnet werden.

Zum Aufbringen einer amorphen Kohlenstoffschicht auf das Trägersubstrat durch einen Lichtbogenprozess unter Einsatz eines Kohlenstofftargets kann der Lichtbogen, z.B. über einen Trigger, mechanisch gezündet werden. Vorzugsweise wird dann ein kontinuierlich brennender DC-Lichtbogen mit einem gepulsten Lichtbogen überlagert. Der kontinuierlich brennende DC-Lichtbogen wird durch einen elektrischen Strom mit einer Stromstärke von bis zu 150 A erzeugt. Der gepulste Lichtbogen wird durch elektrische Strompulse mit einer Pulsfrequenz von bis zu 100 Hz und einer Pulsdauer von bis zu 300 µs erzeugt. Dabei beträgt die maximale elektrische Stromstärke bis zu 1550 A. Der Lichtbogenprozess erzeugt ein ionisiertes Kohlenstoffplasma, das für die Ausbildung einer Lage der Beschichtung auf dem Trägersubstrat abgeschieden wird. Dadurch entsteht auf der Oberfläche des Trägersubstrats mindestens eine amorphe Kohlenstoffschicht.

Während oder nach dem Lichtbogenprozess kann eine streifenförmige Strukturierung unter Verwendung einer Maskierung erzeugt werden. Die Maskierung kann aus einer Anordnung von Metalldrähten bestehen. Die Metalldrähte können verschiedene Querschnittsflächen, z.B. kreisrund oder rechteckig, aufweisen. Durch die geometrische Anordnung der Metalldrähte und/oder durch die Wahl der Querschnittsfläche, können dann unterschiedliche Muster und Geometrien der Strukturierung realisiert werden. Weiterhin kann auch ein entsprechend ausgeschnittenes Metallblech in das Freiräume in Form von Streifen, Kreisen oder polygonalen Strukturen (z.B. Dreieck, Trapez, Parallelogramm, Drachenviereck, Raute, Sechseck usw.) eingebracht sind, sodass derartige Formen sich auf dem beschichteten Trägersubstrat wiederfinden, als Maskierung verwendet werden. Eine so ausgeführte Beschichtung kann zusätzlich auch noch mittels Laserstrukturierung nachbearbeitet werden.

Eine bevorzugt streifenförmige, kreisförmige, kreisringförmige oder polygonale Strukturierung kann auch durch Laserbestrahlung gebildet werden. Die Laserbestrahlung kann beispielsweise mit Hilfe eines cw Lasers mit einer Leistung von 300 W und einer Wellenlänge von 1064 nm durchgeführt werden. Die Strahlauslenkung des Lasers kann dabei durch eine optische Anordnung bestehend aus einem Fokussier- und/oder einem Scannermodul verändert werden. Zusätzlich kann ein Prozessgas, z.B. Stickstoff, zum Einsatz kommen, um die Laseroptik vor Dämpfen und Spritzern zu schützen.

Die Laserbestrahlung kann auch durch einen gepulsten Laser, z.B. einen Nd:YAG-Laser, erfolgen. Dieser wird bevorzugt mit einer Pulslänge von 10 ns, einer Wellenlänge von 1064 nm und einer Pulsenergie von 1 J auf die Oberfläche des Trägersubstrats oder einer Lage der Beschichtung gelenkt.

Die streifenförmigen, kreisförmigen, kreisringförmigen oder polygonalen Bereiche einer dreidimensionalen Strukturierung können auch mittels Laserinterferenzstrukturierung ausgebildet werden. Bei der Laserinterferenzstrukturierung wird der Laserstrahl über eine optische Anordnung so modifiziert, dass eine Aufspaltung in mindestens zwei Teilstrahlen, die auf der Oberfläche des Trägersubstrats oder einer Lage der Beschichtung interferierend wieder überlagert werden, erfolgt. Die Überlagerung und Fokussierung des Laserstrahls erfolgt derart, dass in dem bestrahlten Gebiet Pulsenergiedichten (Laserfluenzen) von vorzugsweise bis zu 1500 mJ/cm² erzielt werden. Die Pulsdauer der verwendeten Laser kann hierbei zwischen 100 Femtosekunden und 100 Nanosekunden liegen. Dabei können streifenförmige, kreisförmige, kreisringförmige, dreieckige, viereckige oder auch sechseckige oder eine Kombination der vorgenannten geometrischen Formen in Form von strukturierten Bereichen in die amorphe Kohlenstoffschicht eingebracht werden. Weiterhin können auch Oberflächen strukturiert werden, die bereits eine beschichtete Oberfläche mit dreidimensionaler Strukturierung unterschiedlicher Formen aufweisen. Bereiche die mittels Laserstrukturierung bearbeitet wurden, weisen hierbei ein größeres sp2/sp3 Hybridisierungsverhältnis bzw. einen höheren Anteil an sp2 hybridisiertem Kohlenstoff auf. Die Laserstrukturierung kann aus streifenförmigen oder punktförmigen Strukturierungen in periodischer Anordnung und Abständen zwischen den Strukturierungen zwischen 0,25 µm und 30 µm, besonders vorzugsweise zwischen 0,5 µm und 10 µm, aufweisen, gebildet werden. Eine vollflächige Strukturierung ist ebenfalls möglich.

Laserbestrahlung und Maskierung können auch kombiniert werden. Insbesondere kann die Maskierung so gewählt werden, dass eine Laserbestrahlung nur in den Bereichen erfolgt, die durch die Maskierung vorgegeben sind. Danach wird die Maskierung entfernt und es können gegebenenfalls weitere Lagen der Beschichtung aufgebracht werden. Die Verwendung einer solchen Maskierung ermöglicht somit eine breite Auswahl an geometrischen Mustern für die dreidimensionale Strukturierung des Trägersubstrats oder einer oder mehrerer Lagen der Beschichtung. Insbesondere kann die Schichtdicke lokal definiert kontrolliert werden, sodass beispielsweise eine mikroskopisch wellenförmige oder sägezahnförmige Struktur gebildet wird.

Eine oder mehrere Lagen der Beschichtung können auch durch Spritzschichten gebildet werden. Spritzschichten können mittels unterschiedlicher Verfahren hergestellt werden. Hierzu zählen beispielsweise Lichtbogendrahtspritzen und Flammspritzen. Insbesondere das Hochgeschwindigkeits-Flammspritzen (HVOF) wirkt sich vorteilhaft aus, da hiermit sehr dichte und gut haftende Schichten erzeugt werden können. Das Spritzgut kann in Pulverform mit einer bevorzugten Korngröße von 0,5 µm bis 100 µm oder als Draht zugeführt werden. Anschließend wird es durch ein brennbares Gas bei einer Temperatur von bis zu 3500 °C aufgeschmolzen. Die Schmelztropfen werden durch den entstehenden hohen Druck auf die zu beschichtende Oberfläche beschleunigt, bevorzugt mit einer Geschwindigkeit von bis zu 550 m/s. Im Spritzgut können unterschiedliche Metalle verwendet werden, z.B. Chrom, Nickel oder Titan, entsprechende Legierungen, oder auch keramische Werkstoffen, z.B. ZrO₂ oder Al₂O₃, eingesetzt werden. Weiterhin kann die Schicht aus in einer Basisschicht mit zusätzlich eingebrachten Hartstoffpartikeln, wie z.B. Wolframkarbid oder Chromkarbid bestehen.

Ein Schneidwerkzeug das gemäß der vorliegenden Erfindung aufgebaut und realisiert wurde kann weitreichende Anwendung finden. Beispielsweise können Haushaltswaren, z.B. Küchenmesser, aber auch Schneidwerkzeuge, die Anwendung in der Medizin und Industrie finden, so ausgebildet sein bzw. so hergestellt werden.

Nachfolgend soll die Erfindung anhand der Figuren 1 bis 3 beispielhaft näher erläutert werden.

Dabei zeigen:
Figur 1 ein Schneidwerkzeug bestehend aus einem Trägersubstrat 1 mit einer Lage 2 einer Beschichtung und einer Schneidkante 3,
Figur 2 einen Schnitt entlang der Linie A-A entsprechend Figur 1 eines Schneidwerkzeugs,
Figur 3 einen Schnitt entlang der Linie A-A entsprechend Figur 1 eines Schneidwerkzeugs mit verschiedenen Beschichtungsvarianten und Maskierungen 8, 9.

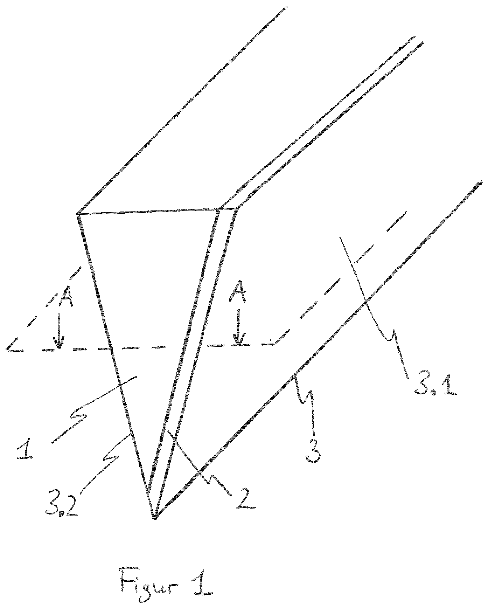

Figur 1 zeigt ein Schneidwerkzeug bestehend aus einem Trägersubstrat 1 aus Stahl mit einer Beschichtung bestehend aus einer Lage 2 der Beschichtung, die mit sp2 und sp3 hybridisiertem Kohlenstoff gebildet ist. Die amorphe Kohlenstoffschicht als Lage 2 der Beschichtung bildet eine Schneidkante 3 des Schneidwerkzeugs und eine äußere Seitenfläche 3.1 des Schneidwerkzeugs, die sich an die Schneidkante 3 des Schneidwerkzeugs anschließt. In Figur 1 bildet die von der Lage 2 der Beschichtung, die mit sp2 und sp3 hybridisiertem Kohlenstoff gebildet ist, abgewandte Oberfläche des Trägersubstrats (1) eine weitere äußere Seitenfläche 3.2 des Schneidwerkzeugs. Alternativ kann diese weitere äußere Seitenfläche 3.2 des Schneidwerkzeugs auch durch eine weitere Lage der Beschichtung, die beispielsweise als Spritzschicht ausgebildet ist, gebildet sein.

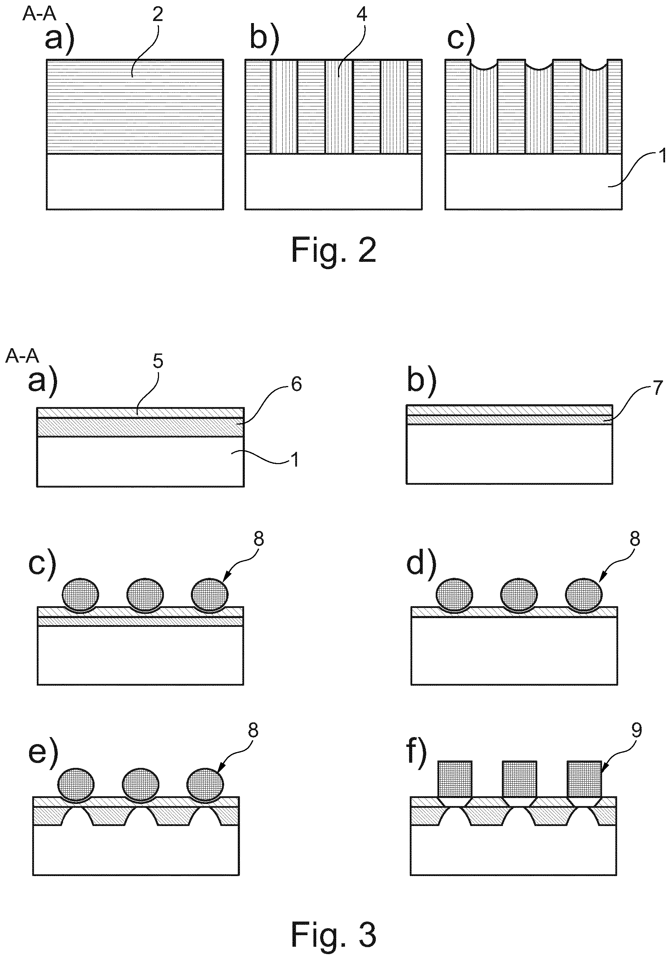

Figur 2 zeigt einen Schnitt entlang der Linie A-A entsprechend Figur 1 eines Schneidwerkzeugs, bei dem ein Trägersubstrat 1 aus Stahl mit einer amorphen Kohlenstoffschicht als Lage 2 der Beschichtung ausgebildet ist. Die amorphe Kohlenstoffschicht als Lage 2 der Beschichtung kann dabei mit Fluor dotiert sein. Der Fluoranteil liegt dabei vorzugsweise zwischen 0,1% und 2 %.

Insbesondere ist die amorphe Kohlenstoffschicht als Lage 2 der Beschichtung in Fig. 2a graduell aufgebaut. Dabei ändert sich das Hybridisierungsverhältnis des Kohlenstoffs entlang eines Gradienten, der parallel zur Normalen der äu-ßeren Seitenfläche, die sich an die Schneidkante 3 anschließt, ausgebildet ist. In diesem Beispiel nimmt der Anteil von sp2 hybridisiertem Kohlenstoff ausgehend von der Oberfläche des Trägersubstrats 1, auf der die Beschichtung angeordnet ist, nach außen hin zu.

In Fig. 2b ist eine graduell aufgebaute amorphe Kohlenstoffschicht als Lage 2 der Beschichtung gezeigt, die zusätzlich zum graduellen Aufbau eine streifenförmige Strukturierung aufweist, sodass streifenförmig laserstrukturierte Bereiche 4 und nicht laserstrukturierte Bereiche entlang der Schneidkante 3 alternierend abwechselnd angeordnet sind. Die streifenförmig laserstrukturierten Bereiche 4 wurden durch eine Laserinterferenzstrukturierung erzeugt. Die Breite der streifenförmig laserstrukturierten Bereiche 4 liegt zwischen 1 µm und 2 mm. Die streifenförmig laserstrukturierten Bereiche 4 sind bei einer gegebenen Schichttiefe stärker grafitisiert als die nicht laserstrukturierten Bereiche bei derselben Schichttiefe. Somit variiert das Hybridisierungsverhältnis des Kohlenstoffs und damit auch der Härtegrad innerhalb der graduell aufgebauten amorphen Kohlenstoffschicht als Lage 2 sowohl von innen nach au-ßen entlang eines vorzugsweise konstanten Gradienten kontinuierlich (gradueller Schichtaufbau), als auch stufenförmig entlang der Schneidkante 3 (streifenförmige Strukturierung). Die Tiefe der Laserstrukturierung kann hierbei auch geringer als die Schichttiefe sein.

Figur 2c zeigt den unterschiedlich starken Verschleiß der streifenförmig laserstrukturierten Bereiche 4 im Vergleich zu den nicht laserstrukturierten Bereichen. Durch die zusätzliche Grafitisierung und damit stärkere Abnutzung der streifenförmig laserstrukturierten Bereiche 4 ergibt sich eine sägezahnartige Struktur. Alternativ, kann eine solche Sägezahnstruktur auch kontrolliert erzeugt werden, vorzugsweise mittels abtragender Laserbestrahlung. Eine derartige Sägezahnstruktur bildet sich auch an der Messerschneide aus.

Fig. 3a zeigt eine Beschichtung mit zwei Lagen, wobei auf einem Trägersubstrat 1 aus Stahl eine erste Lage 6 als nitrierte Randschicht bzw. Nitrierschicht mittels Laserbestrahlung, vorzugsweise mit einer Nitriertiefe zwischen 0,5 µm und 200 µm, ausgebildet ist. Die Nitrierschicht als Lage 6 dient dabei auch als Haftvermittlerschicht für die nachfolgend applizierte amorphe Kohlenstoffschicht als Lage 5. In Fig. 3b ist anstelle der Nitrierschicht als Lage 6 eine Haftvermittlerschicht als Lage 7 aus Chrom aufgebracht. In Fig. 3c ist eine Anordnung wie in Fig. 3b gezeigt, wobei die amorphe Kohlenstoffschicht als Lage 5 zusätzlich streifenförmig strukturiert ist. Eine streifenförmige Strukturierung wird dabei unter Verwendung einer Maskierung bestehend aus Metalldrähten 8 mit einer kreisförmigen Querschnittsfläche erzielt. Dadurch entsteht eine eher wellenförmig streifenförmige Strukturierung der amorphen Kohlenstoffschicht als Lage 5 mit einer variierenden Schichtdicke. Die minimale Schichtdicke liegt bevorzugt zwischen 0 µm und 0,1 µm. Die maximale Schichtdicke liegt bevorzugt zwischen 1 µm und 10 µm. Fig. 3d zeigt eine zu Fig. 3c analoge Maskierung, aber ohne zusätzliche Haftvermittlerschicht als Lage 7 aus Chrom.

Hingegen zeigt Fig. 3e eine Beschichtungsvariante bei der zwischen dem Trägersubstrat 1 und der amorphen Kohlenstoffschicht als Lage 5 eine Nitrierschicht als Lage 6 angeordnet ist, die ebenfalls streifenförmig strukturiert ist. Dabei sind die nitrierten Bereiche mit großer Nitriertiefe zur effizienteren Haftvermittlung unterhalb der Kohlenstoffbereiche, die eine große Schichtdicke aufweisen, angeordnet. Um dies zu erreichen, werden sowohl vor Auftragung der amorphen Kohlenstoffschicht als Lage 5 als auch vor der Nitrierung Metalldrähte 8 senkrecht zur Schneidkante 3 und parallel zur Oberfläche des Trägersubstrats 1 angeordnet.

In Fig. 3f ist eine zu Fig. 3e analoge Variante einer Beschichtung gezeigt, bei der für die Maskierung Metalldrähte 9 mit einer rechteckigen Querschnittsfläche verwendet werden. Durch eine geeignete Wahl von Breite und Abstand der Metalldrähte kann dann eine streifenförmige Strukturierung erfolgen, die eine eher sägezahnförmige Struktur aufweist, insbesondere eine streifenförmige Strukturierung bei der in den abgeschatteten Bereichen fast gar kein Kohlenstoff mehr aufgebracht ist.

Alternativ kann für die Maskierung auch ein Blech mit entsprechenden Freiräumen, innerhalb derer die Beschichtung erfolgt, verwendet werden. Durch eine geeignete Wahl der Freiräume kann eine streifenförmige Strukturierung erfolgen. Es kann aber auch eine Vielzahl weiterer Formen von Freiräumen entstehen und so funktional und dekorativ wirken, indem die Beschichtung sowohl eine eher sägezahnförmige Struktur aufweist, wie beispielsweise eine streifenförmige Strukturierung bei der in den abgeschatteten Bereichen fast gar kein Kohlenstoff mehr aufgebracht ist und gleichzeitig durch die variierende Schichtdicke das optische Erscheinungsbild gestaltet wird.

## Patentansprüche

1. Schneidwerkzeug bestehend aus einem Trägersubstrat (1), einer auf dem Trägersubstrat (1) angeordneten Beschichtung und einer Schneidkante (3), wobei
die Beschichtung mindestens eine Lage (2, 5), die mit sp2 und sp3 hybridisiertem amorphem Kohlenstoff gebildet ist und Eigenschaften aufweist, die zwischen reinem Grafit als sp2 hybridisiert und Diamant als sp3 hybridisiert liegen, aufweist,
**dadurch gekennzeichnet, dass**
die mindestens eine Lage (2, 5) der Beschichtung, die mit sp2 und sp3 hybridisiertem Kohlenstoff gebildet ist, eine dreidimensionale Strukturierung aufweist, wobei
streifenförmige, kreisförmige, kreisringförmige oder polygonale Bereiche dieser Strukturierung mit größerer Schichtdicke mit streifenförmigen, kreisförmigen, kreisringförmigen oder polygonalen Bereichen dieser Strukturierung kleinerer oder keiner Schichtdicke
und/oder
streifenförmige, kreisförmige, kreisringförmige oder polygonale Bereiche dieser Strukturierung, die ein kleineres sp2/sp3 Hybridisierungsverhältnis aufweisen, mit streifenförmigen, kreisförmigen, kreisringförmigen oder polygonalen Bereichen dieser Strukturierung, die ein größeres sp2/sp3 Hybridisierungsverhältnis aufweisen,
alternierend abwechselnd nebeneinander angeordnet sind; wobei
die Differenz zwischen der Schichtdicke der streifenförmigen, kreisförmigen, kreisringförmigen oder polygonalen Bereiche mit kleinerer oder keiner Schichtdicke und der Schichtdicke der streifenförmigen, kreisförmigen, kreisringförmigen oder polygonalen Bereiche mit grö-ßerer Schichtdicke im Bereich 0,1 µm bis 50 µm liegt und
Bereiche mit keiner Schichtdicke nicht beschichtet sind oder dort ein vollständiger Abtrag der Lage (2, 5) der Beschichtung erfolgt ist.

2. Schneidwerkzeug nach dem vorhergehenden Anspruch, **dadurch gekennzeichnet, dass** die streifenförmigen Bereiche der Strukturierung mit ihren mittleren Längsachsen parallel zueinander ausgerichtet sind und streifenförmige Bereiche mit kleinerer oder keiner Schichtdicke und/oder einem größeren sp2/sp3 Hybridisierungsverhältnis eine Breite kleiner als 1 mm aufweisen.

3. Schneidwerkzeug nach einem der vorhergehenden Ansprüche,
**dadurch gekennzeichnet, dass**
eine weitere Lage der Beschichtung, die auf der von der Lage (2, 5) der Beschichtung, die mit sp2 und sp3 hybridisiertem Kohlenstoff gebildet ist, abgewandten Oberfläche des Trägersubstrats (1) angeordnet ist, als thermische Spritzschicht ausgebildet ist
und/oder
eine weitere Lage der Beschichtung, die als thermische Spritzschicht ausgebildet ist, eine weitere äußere Seitenfläche (3.2) des Schneidwerkzeugs bildet.

4. Schneidwerkzeug nach einem der vorhergehenden Ansprüche,
**dadurch gekennzeichnet, dass**
zwischen mindestens einer Lage (2, 5) der Beschichtung, die mit sp2 und sp3 hybridisiertem Kohlenstoff gebildet ist, und einer Oberfläche des Trägersubstrats (1), auf der die Beschichtung angeordnet ist, eine weitere Lage (6, 7) der Beschichtung, die als Nitrierschicht oder Haftvermittlerschicht aus Chrom oder Titannitrid gebildet ist, angeordnet ist.

5. Schneidwerkzeug nach einem der vorhergehenden Ansprüche,
**dadurch gekennzeichnet, dass**
eine weitere Lage (6) der Beschichtung, die als nitrierte Randschicht ausgebildet ist, eine dreidimensionale Strukturierung aufweist, wobei Bereiche größerer Nitriertiefe mit Bereichen kleinerer Nitriertiefe alternierend abwechselnd nebeneinander angeordnet sind.

6. Schneidwerkzeug nach einem der vorhergehenden Ansprüche,
**dadurch gekennzeichnet, dass** mindestens eine Lage (2, 5) der Beschichtung, die mit sp2 und sp3 hybridisiertem Kohlenstoff gebildet ist, mit einem zusätzlichen chemischen Element dotiert ist.

7. Schneidwerkzeug nach einem der vorhergehenden Ansprüche,
**dadurch gekennzeichnet, dass**
mindestens eine Lage (2, 5) der Beschichtung, die mit sp2 und sp3 hybridisiertem Kohlenstoff gebildet ist, einen graduellen Schichtaufbau aufweist, wobei die Dichte und/oder das Hybridisierungsverhältnis sich stufenweise oder kontinuierlich entlang einer Richtung, die parallel zur Normalen der äußeren Seitenfläche (3.1) des Schneidwerkzeugs ausgerichtet ist, verändert ist/sind.

8. Verfahren zur Herstellung eines Schneidwerkzeugs, bei dem eine Oberflächenbehandlung eines Trägersubstrats (1) mit folgenden Schritten durchgeführt wird:
- Einbringen des Trägersubstrats (1) in eine Vakuumkammer, die anschließend auf einen gegenüber dem Umgebungsdruck niedrigen Kammerdruck evakuiert wird
- Reinigung der Oberfläche des Trägersubstrats (1) durch Metallionensputtern
- Aufbringen mindestens einer Lage (2, 5) der Beschichtung, die mit sp2 und sp3 hybridisiertem Kohlenstoff gebildet ist, mittels eines Lichtbogenprozesses unter Einsatz eines Kohlenstofftargets,
**dadurch gekennzeichnet, dass**
während des Aufbringens und/oder nach dem Aufbringen einer Lage (2,5) der Beschichtung, die mit sp2 und sp3 hybridisiertem Kohlenstoff gebildet ist, eine dreidimensionale Strukturierung ausgebildet wird, wobei
die dreidimensionale Strukturierung unter Verwendung einer die dreidimensionale Strukturierung vorgebenden Maske (8, 9), die zwischen dem Kohlenstoff target und der zu beschichtenden Oberfläche des Trägersubstrats (1) während des Aufbringens dieser Lage (2, 5) mittels des Lichtbogenprozesses angeordnet ist, gebildet wird
und/oder
mit mindestens einem Laserstrahl ein lokal definierter Werkstoffabtrag, der zur Ausbildung von streifenförmigen, kreisförmigen, kreisringförmigen oder polygonalen Bereichen mit keiner oder kleinerer Schichtdicke und streifenförmigen, kreisförmigen, kreisringförmigen oder polygonalen Bereichen mit einer oder größerer Schichtdicke, der mit sp2 und sp3 hybridisiertem Kohlenstoff gebildeten Lage (2, 5) der Beschichtung, führt, durchgeführt wird
und/oder
die dreidimensionale Strukturierung unter Einsatz mindestens eines Laserstrahls durch eine lokal definierte Modifizierung der Lage (2, 5), bei der streifenförmige, kreisförmige, kreisringförmige oder polygonale Bereiche mit einem größeren sp2/sp3 Hybridisierungsverhältnis, alternierend neben streifenförmigen, kreisförmigen, kreisringförmigen oder polygonalen Bereichen, die ein kleineres sp2/sp3 Hybridisierungsverhältnis aufweisen, angeordnet werden, ausgebildet wird; wobei
Bereiche mit keiner Schichtdicke nicht beschichtet werden oder dort ein vollständiger Abtrag der Lage (2, 5) der Beschichtung, die mit sp2 und sp3 hybridisiertem Kohlenstoff gebildet ist, erfolgt.

9. Verfahren nach Anspruch 8, **dadurch gekennzeichnet, dass** während des Aufbringens einer Lage (2, 5) der Beschichtung, die mit sp2 und sp3 hybridisiertem Kohlenstoff gebildet ist, eine Dotierung durch Zufuhr von Prozessgasen oder den Einsatz eines Dotierungstargets erfolgt.

10. Verfahren nach Anspruch 8 oder 9, **dadurch gekennzeichnet, dass**
eine weitere Lage der Beschichtung, die auf der von der Lage (2, 5) der Beschichtung, die mit sp2 und sp3 hybridisiertem Kohlenstoff gebildet wird, abgewandten Oberfläche (3.2) des Trägersubstrats (1) angeordnet wird, als thermische Spritzschicht ausgebildet wird
und/oder
mit einer weiteren Lage der Beschichtung, die als thermische Spritzschicht ausgebildet wird, eine weitere äußere Seitenfläche (3.2) des Schneidwerkzeugs gebildet wird.

11. Verfahren nach Anspruch 8, 9 oder 10, **dadurch gekennzeichnet, dass**
zwischen mindestens einer Lage (2, 5) der Beschichtung, die mit sp2 und sp3 hybridisiertem Kohlenstoff gebildet wird, und einer Oberfläche des Trägersubstrats (1), auf der die Beschichtung angeordnet wird, eine weitere Lage (6, 7) der Beschichtung, die als Nitrierschicht oder Haftvermittlerschicht aus Chrom oder Titannitrid gebildet wird, angeordnet wird.

12. Verfahren nach Anspruch8, 9, 10 oder 11, **dadurch gekennzeichnet, dass** vor dem Aufbringen einer Lage (2, 5) der Beschichtung, die mit sp2 und sp3 hybridisiertem Kohlenstoff gebildet ist, mindestens eine weitere Lage (6) der Beschichtung, die als eine nitrierte Randschicht ausgebildet wird, auf der Oberfläche des Trägersubstrats (1), auf der die Beschichtung angeordnet wird, gebildet wird, wobei insbesondere während des Nitrierens eine dreidimensionale Strukturierung, bei der Bereiche größerer Nitriertiefe mit Bereichen kleinerer Nitriertiefe alternierend abwechselnd nebeneinander angeordnet werden, unter Verwendung einer Maske (8, 9) und/oder mittels Laserstrahlung ausgebildet wird.

13. Verfahren nach einem der Ansprüche 8, 9, 10, 11 oder 12, **dadurch gekennzeichnet, dass** streifenförmige, kreisförmige, kreisringförmige oder polygonale Bereiche (4) einer dreidimensionalen Strukturierung mittels Laserinterferenzstrukturierung ausgebildet werden.

## Claims

1. A cutting tool consisting of a carrier substrate (1), a coating arranged on the carrier substrate (1) and a cutting edge (3), wherein
the coating has at least one layer (2, 5) formed with sp2 and sp3 hybridized amorphous carbon and having properties which are between pure graphite hybridized as sp2 and diamond as sp3,
**characterized in that**
the at least one layer (2, 5) of the coating formed with sp2 and sp3 hybridized carbon has a three-dimensional structuring, wherein
strip-shaped, circular, annular or polygonal regions of this structuring with greater coating thickness are arranged alternately side by side with strip-shaped, circular, annular or polygonal regions of this structuring of smaller or no coating thickness
and/or
strip-shaped, circular, annular or polygonal regions of this structuring, which have a smaller sp2/sp3 hybridization ratio, are arranged alternately side by side with strip-shaped, circular, annular or polygonal regions of this structuring, which have a larger sp2/sp3 hybridization ratio; wherein
the difference between the coating thickness of the strip-shaped, circular, annular or polygonal regions with smaller or no coating thickness and the coating thickness of the strip-shaped, circular, annular or polygonal regions with greater coating thickness is in the range of 0.1 pm to 50 pm, and
regions with no coating thickness are not coated or complete removal of the layer (2, 5) of the coating has occurred there.

2. The cutting tool according to the preceding claim, **characterized in that** the strip-shaped regions of the structuring are aligned with their central longitudinal axes parallel to one another and strip-shaped regions with smaller or no coating thickness and/or a larger sp2/sp3 hybridization ratio have a width smaller than 1 mm.

3. The cutting tool according to any of the preceding claims, **characterized in that**
a further layer of the coating, which is arranged on the surface of the carrier substrate (1) facing away from the layer (2, 5) of the coating formed with sp2 and sp3 hybridized carbon, is formed as a thermal spray coating
and/or
a further layer of the coating formed as a thermal spray coating forms a further outer lateral surface (3.2) of the cutting tool.

4. The cutting tool according to any of the preceding claims, **characterized in that**
between at least one layer (2, 5) of the coating formed with sp2 and sp3 hybridized carbon and a surface of the carrier substrate (1) on which the coating is disposed, another layer (6, 7) of the coating formed as a nitriding layer or adhesion promoting layer of chromium or titanium nitride is disposed.

5. The cutting tool according to any of the preceding claims, **characterized in that**
a further layer (6) of the coating, which is formed as a nitrided edge layer, has a three-dimensional structuring, wherein regions of greater nitriding depth are alternately arranged next to one another with regions of lesser nitriding depth.

6. The cutting tool according to any one of the preceding claims, **characterized in that** at least one layer (2, 5) of the coating formed with sp2 and sp3 hybridized carbon is doped with an additional chemical element.

7. The cutting tool according to any of the preceding claims, **characterized in that**
at least one layer (2, 5) of the coating formed with sp2 and sp3 hybridized carbon has a gradual layer structure, wherein the density and/or the hybridization ratio is/are changed gradually or continuously along a direction aligned parallel to the normal of the outer lateral surface (3.1) of the cutting tool.

8. A method of manufacturing a cutting tool, wherein a surface treatment of a carrier substrate (1) is carried out with the following steps:
- inserting the carrier substrate (1) into a vacuum chamber, which is then evacuated to a chamber pressure that is low compared to the ambient pressure
- cleaning the surface of the carrier substrate (1) by metal ion sputtering
- applying at least one layer (2, 5) of the coating formed with sp2 and sp3 hybridized carbon by an arc process using a carbon target,
**characterized in that**
during application and/or after application of a layer (2,5) of the coating formed with sp2 and sp3 hybridized carbon, a three-dimensional structuring is formed, wherein
the three-dimensional structuring is formed using a mask (8, 9) which predetermines the three-dimensional structuring and is arranged between the carbon target and the surface of the carrier substrate (1) to be coated during the application of this layer (2, 5) by means of the arc process
and/or
a locally defined material ablation is carried out with at least one laser beam, which ablation leads to the formation of strip-shaped, circular, annular or polygonal regions with no or smaller coating thickness and strip-shaped, circular, annular or polygonal regions with a layer thickness of the layer (2, 5) of the coating formed with sp2 and sp3 hybridized carbon or greater,
and/or
the three-dimensional structuring is formed using at least one laser beam by a locally defined modification of the layer (2, 5), in which strip-shaped, circular, annular or polygonal regions having a larger sp2/sp3 hybridization ratio are arranged alternately next to strip-shaped, circular, annular or polygonal regions having a smaller sp2/sp3 hybridization ratio; wherein
regions with no coating thickness are not coated or a complete removal of the ablation of the layer (2, 5) of the coating formed with sp2 and sp3 hybridized carbon is carried out there.

9. The method of claim 8, **characterized in that** during the application of a layer (2, 5) of the coating formed with sp2 and sp3 hybridized carbon, doping is performed by supplying process gases or the use of a doping target.

10. The method according to claim 8 or 9, **characterized in that**
a further layer of the coating, which is arranged on the surface (3.2) of the carrier substrate (1) facing away from the layer (2, 5) of the coating formed with sp2 and sp3 hybridized carbon, is formed as a thermal spray coating
and/or
with a further layer of the coating, which is formed as a thermal spray coating, a further outer lateral surface (3.2) of the cutting tool is formed.

11. The method according to claim 8, 9 or 10, **characterized in that**
between at least one layer (2, 5) of the coating formed with sp2 and sp3 hybridized carbon and a surface of the carrier substrate (1) on which the coating is disposed, a further layer (6, 7) of the coating formed as a nitriding layer or a chromium or titanium nitride adhesion promoting layer is disposed.

12. The method according to claim 8, 9, 10 or 11, **characterized in that** prior to the application of a layer (2, 5) of the coating formed with sp2 and sp3 hybridized carbon, at least one further layer (6) of the coating, formed as a nitrided edge layer, is formed on the surface of the carrier substrate (1) on which the coating is arranged, wherein, in particular during nitriding, a three-dimensional structuring, in which regions of greater nitriding depth are alternately arranged next to one another with regions of smaller nitriding depth, is formed using a mask (8, 9) and/or by means of laser radiation.

13. The method according to one of claims 8, 9, 10, 11 or 12, **characterized in that** strip-shaped, circular, annular or polygonal regions (4) of a three-dimensional structuring are formed by means of laser interference structuring.

## Revendications

1. Outil de coupe constitué d'un substrat porteur (1), d'un revêtement disposé sur le substrat porteur (1) et d'une arête de coupe (3), dans lequel
le revêtement présente au moins une couche (2, 5), qui est formée avec du carbone amorphe hybridé sp2 et sp3 et présente des propriétés qui se situent entre le graphite pur hybridé en tant que sp2 et le diamant hybridé en tant que sp3,
**caractérisé en ce que**
la au moins une couche (2, 5) du revêtement, qui est formée avec du carbone hybridé sp2 et sp3, présente une structuration tridimensionnelle, dans lequel
des zones en forme de bande, en forme de cercle, en forme d'anneau circulaire ou polygonales de cette structuration avec une épaisseur de couche plus importante sont disposées alternativement en alternance les unes à côté des autres avec des zones en forme de bande, en forme de cercle, en forme d'anneau circulaire ou polygonales de cette structuration d'une épaisseur de couche plus petite ou nulle
et/ou
des zones en forme de bande, en forme de cercle, en forme d'anneau circulaire ou polygonales de cette structuration, qui présentent un rapport d'hybridation sp2/sp3 plus petit, sont disposées en alternance les unes à côté des autres avec des zones en forme de bande, en forme de cercle, en forme d'anneau circulaire ou polygonales de cette structuration, qui présentent un rapport d'hybridation sp2/sp3 plus important ;
dans lesquelles
la différence entre l'épaisseur de couche des zones en forme de bande, en forme de cercle, en forme d'anneau circulaire ou polygonales avec une épaisseur de couche plus petite ou nulle et l'épaisseur de couche des zones en forme de bande, en forme de cercle, en forme d'anneau ou polygonales avec une épaisseur de couche plus importante se situe dans la plage de 0,1 µm à 50 µm et
les zones sans épaisseur de couche ne sont pas revêtues ou un enlèvement complet de la couche (2, 5) du revêtement y a été effectué.

2. Outil de coupe selon la revendication précédente, **caractérisé en ce que** les zones en forme de bande de la structuration sont orientées avec leurs axes longitudinaux centraux parallèlement les unes aux autres et les zones en forme de bandes avec une épaisseur de couche plus petite ou nulle et/ou un rapport d'hybridation sp2/sp3 plus important présentent une largeur inférieure à 1 mm.

3. Outil de coupe selon l'une quelconque des revendications précédentes, **caractérisé en ce que**
une autre couche du revêtement, qui est appliquée sur la surface du substrat porteur (1) opposée à la couche (2, 5) du revêtement, qui est formée avec du carbone hybridé sp2 et sp3, est réalisée sous forme de couche de projection thermique
et/ou
une autre couche du revêtement, qui est réalisée sous forme de couche de projection thermique, forme une autre surface latérale extérieure (3.2) de l'outil de coupe.

4. Outil de coupe selon l'une quelconque des revendications précédentes, **caractérisé en ce que**
entre au moins une couche (2, 5) du revêtement, qui est formée avec du carbone hybridé sp2 et sp3, et une surface du substrat porteur (1), sur laquelle est disposé le revêtement, est disposée une autre couche (6, 7) du revêtement, qui est formée comme couche de nitruration ou couche d'agent adhésif en chrome ou en nitrure de titane.

5. Outil de coupe selon l'une quelconque des revendications précédentes, **caractérisé en ce que**
une autre couche (6) du revêtement, qui est réalisée sous forme de couche marginale nitrurée, présente une structuration tridimensionnelle, dans lequel des zones de plus grande profondeur de nitruration sont disposées alternativement en alternance les unes à côté des autres avec des zones de plus petite profondeur de nitruration.

6. Outil de coupe selon l'une quelconque des revendications précédentes, **caractérisé en ce qu'**au moins une couche (2, 5) du revêtement, qui est formée avec du carbone hybridé sp2 et sp3, est dopée avec un élément chimique supplémentaire.

7. Outil de coupe selon l'une quelconque des revendications précédentes, **caractérisé en ce que**
au moins une couche (2, 5) du revêtement, qui est formée avec du carbone hybridé sp2 et sp3, présente une structure de couche graduelle, dans lequel la densité et/ou le rapport d'hybridation est/sont modifié(s) par étapes ou en continu le long d'une direction qui est orientée parallèlement à la normale de la surface latérale extérieure (3.1) de l'outil de coupe.

8. Procédé de fabrication d'un outil de coupe, selon lequel un traitement de surface d'un substrat porteur (1) est mis en oeuvre avec les étapes suivantes :
- l'introduction du substrat porteur (1) dans une chambre à vide, qui est ensuite mise sous vide à une pression de chambre inférieure à la pression ambiante
- le nettoyage de la surface du substrat porteur (1) par pulvérisation cathodique aux ions métalliques
- l'application d'au moins une couche (2, 5) du revêtement, qui est formée avec du carbone hybridé sp2 et sp3, au moyen d'un processus d'arc électrique utilisant une cible de carbone,
**caractérisé en ce que**
pendant l'application et/ou après l'application d'une couche (2, 5) du revêtement, qui est formée avec du carbone hybridé sp2 et sp3, une structuration tridimensionnelle est réalisée, dans lequel
la structuration tridimensionnelle est formée en utilisant un masque (8, 9) prédéfinissant la structuration tridimensionnelle, qui est disposé entre la cible de carbone et la surface à revêtir du substrat porteur (1) pendant l'application de cette couche (2, 5) au moyen du processus à l'arc électrique
et/ou
un enlèvement de matière défini localement, qui conduit à la réalisation de zones en forme de bande, en forme de cercle, en forme d'anneau circulaire ou polygonales avec une épaisseur de couche plus petite ou nulle et de zones en forme de bande, en forme de cercle, en forme d'anneau circulaire ou polygonales avec une épaisseur de couche ou une épaisseur de couche plus importante, de la couche (2, 5) du revêtement formée avec du carbone hybridé sp2 et sp3, est mis en oeuvre avec au moins un faisceau laser
et/ou
la structuration tridimensionnelle est réalisée en utilisant au moins un faisceau laser par une modification définie localement de la couche (2, 5), dans laquelle des zones en forme de bande, en forme de cercle, en forme d'anneau circulaire ou polygonales avec un rapport d'hybridation sp2/sp3 plus important sont disposées en alternance à côté de zones en forme de bande, en forme de cercle, en forme d'anneau circulaire ou polygonales, qui présentent un rapport d'hybridation sp2/sp3 plus petit ; dans lequel
les zones sans épaisseur de couche ne sont pas revêtues ou un enlèvement complet de la couche (2, 5) du revêtement, qui est formée avec le carbone hybridé sp2 et sp3, s'effectue.

9. Procédé selon la revendication 8, **caractérisé en ce que**, pendant l'application d'une couche (2, 5) du revêtement, qui est formée avec du carbone hybridé sp2 et sp3, un dopage s'effectue par amenée de gaz de traitement ou l'utilisation d'une cible de dopage.

10. Procédé selon la revendication 8 ou 9, **caractérisé en ce que**
une autre couche du revêtement, qui est disposée sur la surface (3.2) du substrat porteur (1) opposée à la couche (2, 5) du revêtement, qui est formée avec du carbone hybridé sp2 et sp3 est réalisée en tant que couche de projection thermique
et/ou
une autre surface latérale extérieure (3.2) de l'outil de coupe est formée avec une autre couche du revêtement, qui est réalisée en tant que couche de projection thermique.

11. Procédé selon la revendication 8, 9 ou 10, **caractérisé en ce que**
une autre couche (6, 7) du revêtement, qui est formée en tant que couche de nitruration ou couche d'agent adhésif en chrome ou nitrure de titane, est disposée entre au moins une couche (2, 5) du revêtement, qui est formée avec du carbone hybridé sp2 et sp3, et une surface du substrat porteur (1), sur laquelle le revêtement est disposé.

12. Procédé selon la revendication 8, 9, 10 ou 11, **caractérisé en ce que** avant l'application d'une couche (2, 5) du revêtement, qui est formée avec du carbone hybridé sp2 et sp3, au moins une autre couche (6) du revêtement, qui est réalisée en tant que couche marginale nitrurée, est formée sur la surface du substrat porteur (1), sur laquelle le revêtement est disposé, dans lequel en particulier pendant la nitruration, une structuration tridimensionnelle, dans laquelle des zones de plus grande profondeur de nitruration sont disposées alternativement en alternance les unes à côté des autres avec des zones de plus petite profondeur de nitruration, est réalisée en utilisant un masque (8, 9) et/ou au moyen d'un rayonnement laser.

13. Procédé selon l'une quelconque des revendications 8, 9, 10, 11 ou 12, **caractérisé en ce que** des zones (4) en forme de bande, en forme de cercle, en forme d'anneau circulaire ou polygonales d'une structuration tridimensionnelle sont réalisées au moyen d'une structuration par interférence laser.
